# EUROPEAN PATENT APPLICATION

(11) **EP 1 788 724 A1**
(43) Date of publication of application: **23.05.2007**
(21) Application number: 05783909.4
(22) Date of filing: 07.09.2005
(51) Int. Cl.: H04B 7/26

(54) **A HAND-HELD EQUIPMENT FOR PROLONGING OPERATING TIME AND IMPLENTATION METHOD THEREOF**

(30) Priority: 07.09.2004 CN 200410074568
(71) Applicant: Huawei Technologies Co., Ltd., Longgang District, Shenzhen Guangdong 518129 (CN)
(72) Inventor: WANG, Hai, Shenzhen, Guangdong 518129 (CN)
(74) Representative: Thun, Clemens
(86) International application number: PCT/CN2005/001420
(87) International publication number: WO 2006/026919

(57) **Abstract**

The present invention discloses a portable device with prolonged working hours, which includes a radio frequency process module, an antenna module, and a Power Amplifier (PA) process module. The PA process module is used to transmit a radio frequency signal directly to the antenna module when output power of the antenna module is not larger than maximum input power which the portable device can provide for the antenna module; to amplify power of the radio frequency signal through its PA module, send the radio frequency signal with amplified power to the antenna module when the output power of the antenna module is larger than the maximum input power which the portable device can provide for the antenna module. A method for prolonging working hours of a portable device is provided. In the invention, energy consumption of the PA module is reduced, and working hours of the portable device is greatly prolonged.

## Description

### Field of the Technology

The present invention relates to radio frequency transmission technology, and more particularly, to a portable device with prolonged working hours and a method for prolonging working hours of a portable device.

### Background of the Invention

Both Code Division Multiple Access (CDMA) portable device and Wideband Code Division Multiple Access (WCDMA) portable device nowadays transmit a radio frequency signal through a radio frequency transmission channel.

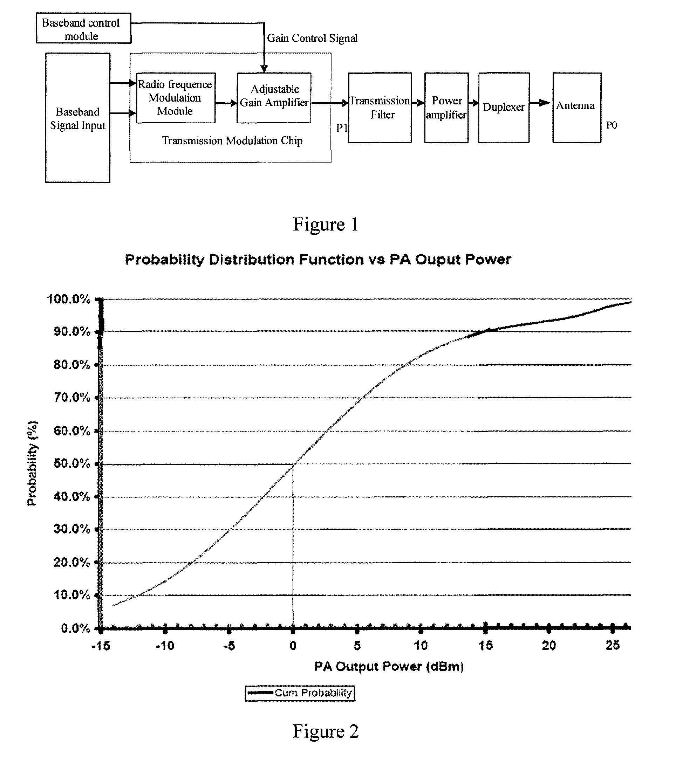

A typical circuit structure of the radio frequency transmission channel is shown in Figure 1. Before being sent out through an antenna, the radio frequency signals are processed by the radio frequency transmission channel first: baseband signals are input from baseband; the baseband signals are modulated by a radio frequency modulation module in a transmission modulation chip, then radio frequency signals with different radio frequency powers are output by an adjustable gain amplifier, and the output process is under the control of a gain control signal output by a baseband control module; the radio frequency signals are filtered by a transmission filter to eliminate part of the noise; the filtered radio frequency signals are then amplified by a Power Amplifier (PA); the amplified signals are finally sent to the antenna through a duplexer. After all the above operations, the processed radio frequency signals can be transmitted wirelessly by the antenna. The PA is just required to perform fixed-gain amplification.

The transmission power of the portable device should be as small as possible according to the requirement of CDMA & WCDMA, however, the portable device has to transmit larger power radio frequency signal if it is far away from a base station. The specific value of the transmission power is determined by the baseband control module in the circuit structure shown in Figure 1. For instance, if the portable device is close to the base station, a radio frequency signal with a smaller power which is output by the adjustable gain amplifier is required by the baseband control module through the gain control signal; while if the portable device is far away from the base station, the baseband control module requires a radio frequency signal with a larger power output by the adjustable gain amplifier through the gain control signal. Being adjusted by the adjustable gain amplifier, the radio frequency signals with different frequencies are output through the fixed-gain amplification of the PA mentioned above.

The power of the radio frequency signal acquired by the transmission modulation chip in the above process is called P1. The power of the radio frequency signal which the antenna needs to send out is called P0. At present the requirements upon the two powers are different in the industry. For example, in WCDMA CLASSIII terminal devices, the output power of the antenna should be P0 = - 50dBm ~ 24dBm according to the protocol, however, the maximum power which most transmission modulation chips can realize is P1=4dBm, or a little larger. Actually, the input transmission power provided by the transmission modulation chip can meet the output power requirement of the antenna directly in most cases. This situation is further explained according to the relation between the output power of the antenna and that of the transmission modulation chip in the terminal as follows, as shown in Figure 2.

The x axis in Figure 2 represents the output power of the port of the portable device antenna required by the current protocol. The y axis represents the statistics probability when the actual output power of the antenna in the portable device is smaller than x. As can be seen in Figure 2, the output power of the portable device is smaller than 0dBm in 50 % of its working hours, while the maximum output power of the transmission modulation chip is generally P1=4dBm. In these working hours, signal output power requirement of the antenna can be well satisfied by the input transmission power provided by the transmission modulation chip, thus it is not necessary to process the signal through the PA any more.

Actually, even if it is possible to make the transmission power of the transmission modulation chip the same as the signal output power of the antenna by the modulation of the baseband control module, it should not process like that because of the existence of the PA with the fixed-gain amplification function. Instead, the transmission power should be set to a lower power value, and then be amplified by the PA. As far as the PA is concerned, the signal should be processed all the time, that is to say, the PA is always working in a signal amplification state, in which a 60mA~ 90mA quiescent current should be kept, causing power loss, reducing complete machine efficiency, and shortening conversation time of the terminals apparently.

### Summary of the Invention

A portable device with prolonged working hours is provided.

A method for implementing the portable device with prolonged working hours is also provided. A portable device with prolonged working hours, includes:
a radio frequency process module for modulating a baseband signal and generating a radio frequency signal;
an antenna module for sending out the radio frequency signal;
a Power Amplifier (PA) process module connected to the radio frequency process module and the antenna module respectively, including a PA module for amplifying the power of the radio frequency signal, wherein,
the PA module works in an idle state when no radio frequency signal passes;
and, transmits the radio frequency signal directly to the antenna module when the output power of the antenna module is not larger than the maximum input power which the portable device can provide for the antenna module, amplifies the power of the radio frequency signal through the PA module and sends the radio frequency signal with an amplified power to the antenna module when the output power of the antenna module is larger than the maximum input power which the portable device can provide for the antenna module.

The portable device further includes:
a baseband control module;
a switch module in the PA process module, where,
the baseband control module is used to send a control signal to the switch module for transmitting the radio frequency signal directly to the antenna module when the output power of the antenna module is not larger than the maximum input power which the portable device can provide for the antenna module; and to send a control signal to the switch module for transmitting the radio frequency signal to the antenna module through the PA module when the output power of the antenna module is larger than the maximum input power which the portable device can provide for the antenna module;
the switch module is used to transmit the received radio frequency signal directly to the antenna module, or to send the received radio frequency signal to the PA module for amplifying the power, and send the radio frequency signal with the amplified power to the antenna module according to the control signal sent by the baseband control module.

The switch module includes two switches and a transmission line, one end of the first switch connects to the radio frequency process module, the other end connects to the PA module, one end of the second switch connects to the PA module, the other end connects to the antenna module, and the two switches are also connected with each other directly through the transmission line;
the switch module transmits the radio frequency signal received by the first switch directly to the antenna module through the transmission line and the second switch, or transmits the radio frequency signal received by the first switch to the PA module, and the second switch sends the radio frequency signal processed by the PA module to the antenna module according to the control signal sent by the baseband control module.

The radio frequency process module includes:
a transmission modulation chip, which is used for implementing a modulation and gain amplification of the baseband signal, and the transmission of the processed radio frequency signal to a transmission filtering module;
the transmission filtering module, which is used for filtering the received radio frequency signal and transmitting the radio frequency signal to the PA process module after the filtering.
where, the PA process module connects to the antenna module through the duplex module.

A method for prolonging working hours of a portable device, includes:
acquiring a radio frequency signal, by the portable device, through a radio frequency modulation on a baseband signal;
configuring the work state of a Power Amplifier (PA) module in the portable device to be idle when no radio frequency signal passes;
determining, by the portable device, whether the transmission power of an antenna module in the portable device is larger than the maximum input power which the portable device can provide for the antenna module,
if the transmission power of the antenna module in the portable device is not larger than the maximum input power which the portable device can provide for the antenna module, the portable device sending out the modulated radio frequency signal directly through the antenna module, and ending the process;
otherwise the portable device amplifying the power of the modulated radio frequency signal through the PA module, and sending out the processed radio frequency signal through the antenna module.

The maximum input power which the portable device can provide for the antenna module is the maximum transmission frequency of the radio frequency signal acquired from the radio frequency modulation of the portable device.

The maximum input power which the portable device can provide for the antenna module is the difference of the maximum transmission frequency of the radio frequency signal acquired from the radio frequency modulation of the portable device and the transmission power loss of the portable device.

The portable device includes a transmission filtering module which is used for filtering,
the transmission power loss includes the power loss of the transmission filtering module;
the portable device includes a duplex module which is used for duplex processing,
and the transmission power loss includes the power loss of the duplex module.

The portable device controls the transmission of the radio frequency signal through a switch module, and the transmission power loss includes the power loss of the switch module.

In the invention, through configuring the PA process module in the portable device which can directly transmit the signal to the antenna module, and setting the PA module in the PA process module to be idle when no radio frequency signal passes, it is possible for the PA process module in the portable device to transmit the signal directly to the antenna module when the output power of the antenna module is not larger than the maximum input power which the portable device can provide for the antenna module. Because the PA is in idle state at this time, during which current consumption of the PA module is in uA level, the power loss of the PA module can be reduced while the normal communication is guaranteed in the invention, which greatly prolongs the working hours of the portable device and improves the complete machine efficiency.

### Brief Description of the Drawings

Figure 1 is a diagram illustrating a circuit structure of a radio frequency transmission channel in a portable device in the related art;
Figure 2 is a schematic diagram illustrating a scale relation between standard and actual output power of an antenna.
Figure 3 is a diagram illustrating a circuit structure of a radio frequency transmission channel of a portable device in accordance with an embodiment of the present invention.
Figure 4 is a flow chart illustrating a method in accordance with an embodiment of the present invention.

### Embodiments of the Invention

The embodiments of the present invention improve the circuit structure of the radio frequency transmission channel in the portable device, making it possible to send the radio frequency signal directly to an antenna module without power amplification when the radio frequency power output by the transmission modulation chip can meet the transmission requirement of the antenna without the power amplification. Further descriptions to specific embodiments of the invention are given in detail as follows.

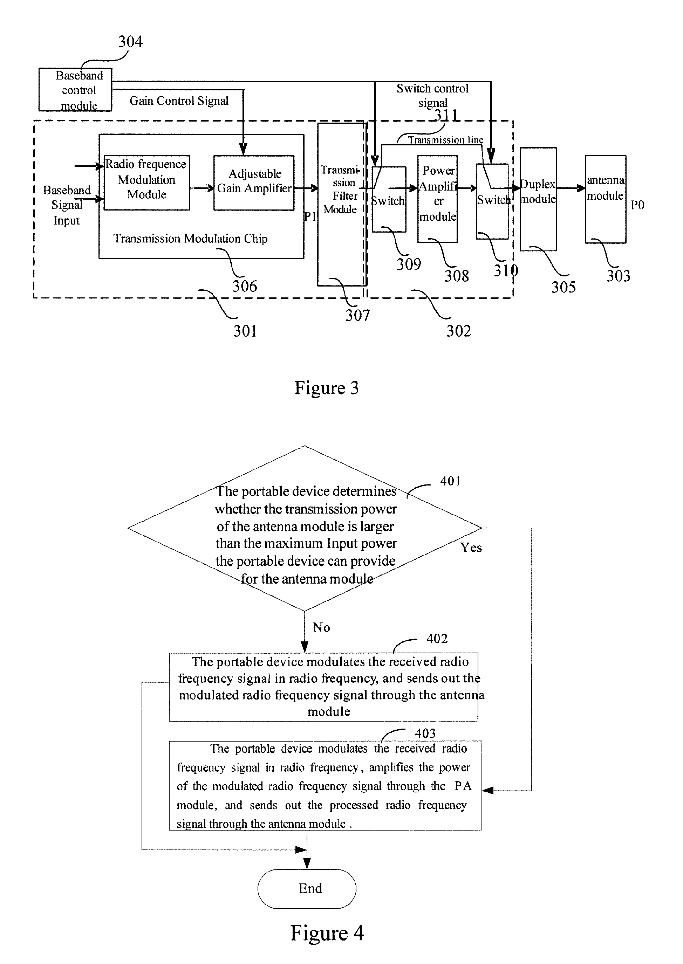

The circuit structure of the radio frequency transmission channel in accordance with an embodiment of the present invention is shown in Figure 3, including a radio frequency process module 301, a PA process module 302, and an antenna module 303.

The radio frequency process module 301 includes a transmission modulation chip 306, which is used for implementing the modulation and gain amplification of the baseband signal. The radio frequency process module 301 can also include a transmission filtering module 307, which is used for filtering the signal processed by the transmission modulation chip 306, and transmitting the processed signal to the PA process module 302.

The PA process module 302 connecting to the radio frequency process module 301 and the antenna module 303 respectively is used to transmit the radio frequency signal directly to the antenna module 303 when the output power of the antenna module 303 is not larger than the maximum input power which the portable device can provide for the antenna module 303, or to amplify the power of the radio frequency signal and send the amplified radio frequency signal to the antenna module 303 when the output power of the antenna module 303 is larger than the maximum input power which the portable device can provide for the antenna module 303. Moreover, the work state of the PA module 308 in the PA process module 302 should be set to the idle state when no radio frequency signal passes, which will reduce power consumption of the PA module 308, because the PA module only needs currents in uA level in the idle state.

The function of the PA process module 302 can be specifically carried out by the PA module 308 and a switch module. The switch module includes two switches 309, 310 and a transmission line 311, one end of the switch 309 connects to the radio frequency process module 301, the other end connects to the PA module 308, one end of the switch 310 connects to the PA module 308, the other end connects to the antenna module 303, both of the switches are connected directly through the transmission line 311 as well. If the output power of the antenna module 303 is not larger than the maximum input power which the portable device can provide for the antenna module 303, the switch module will tr ansmit the radio frequency signal directly to the antenna module 303, that is to say, the switch 309 will transmit the signal directly to the switch 310 through the transmission line 311, then the switch 310 will transmit the signal to the antenna module 303; otherwise, the switch 309 in the switch module will send the signal to the PA module 308 first, then the PA module 308 will transmit the amplified signal to the switch 310, which will transmit the signal to the antenna module 303 at last.

To implement the control of the PA process module, a baseband control module 304 can be configured in the above circuit. The baseband control module 304 makes a judgment on the needed output power of the antenna module 303 and the maximum input power which the portable device can provide for the antenna module 303, if the former is larger than the latter, it is necessary to amplify the power of the signal through the PA in the PA process module 302, thus a control signal is sent to the PA process module 302 for the control of transmitting the radio frequency signal to the PA module 308 by the switch 309, then the radio frequency signal amplified by the PA module 308 is transmitted to the antenna module 303 by the switch 310; otherwise, the radio frequency signal can be directly transmitted to the antenna module 303, thus a control signal is sent to the PA process module 302 for the control of the direct transmission of the radio frequency signal from the switch 309 to the switch 310 through the transmission line.

Of course, a duplex module 305 can also be configured in the above circuit, through which the PA process module 302 can send the radio frequency signal to the antenna module 303.

When the baseband control module 304 is making the judgment on the two powers, if possible power loss in the circuit can be omitted, the maximum output power of the transmission modulation chip 306 in the radio frequency process module 301 can be adopted as the maximum input power which the portable device can provide for the antenna module 303. Of course, if the power loss in the circuit can not be omitted, the maximum input power of the antenna module 303 should be the difference of the maximum output power of the transmission modulation chip 306 in the radio frequency process module 301 and the power loss.

The power loss may come from the transmission filtering module, or from the switch module in the PA process module, or from the duplex module, or, of course, from all of these modules. The power loss can be estimated in advance, that is to say, the power loss can be preset according to the possible loss in the portable device. So, assuming the power loss is L1, the output power of the antenna module is P0, the maximum output power of the transmission modulation chip is P1, then the judgment would be judging whether P0≤ (P1-L1).

Based on the portable device described above, detailed description of the method in accordance with an embodiment of the present invention is given as follows:

As shown in Figure 4, the following steps are involved in implementation of the embodiment of the present invention:
Step 401: The portable device determines whether the transmission power of the antenna module in the device is larger than the maximum input power which the device can provide for the antenna module, if the transmission power of the antenna module in the device is not larger than the maximum input power which the device can provide for the antenna module, proceed to Step 402, otherwise proceed to Step 403;
Step 402: The portable device modulates the received radio frequency signal in radio frequency, and sends out the modulated radio frequency signal through the antenna module, then ends the process;
Step 403: The portable device modulates the received radio frequency signal in radio frequency, amplifies the power of the modulated radio frequency signal through the PA module, and sends out the processed radio frequency signal through the antenna module.

In an embodiment of the present invention, the baseband control module in the portable device adopts the maximum transmission frequency of the radio frequency signal acquired from the radio frequency modulation of the portable device as the maximum input power mentioned above which the device can provide for the antenna module to realize the judgment described in Step 401 above;

In another embodiment of the present invention, the baseband control module in the portable device can also adopt the difference of the maximum transmission frequency of the radio frequency signal acquired from the radio frequency modulation of the portable device and the transmission power loss of the portable device as the maximum input power which the above device can provide for the antenna module to realize the judgment described in the Step 401 mentioned above; in other embodiments of the present invention, if the portable device includes the transmission filtering module which is used for filtering and/or includes the duplex module which is used for duplex processing, the above transmission power loss should further includes the power loss of the transmission filtering module and/or the duplex module; when the portable device controls the transmission of the radio frequency signal through the switch module, the above transmission power loss should further includes the power loss of the switch module mentioned above.

The descriptions above are just preferred embodiments of the present invention, which is not used for limiting the protection scope of the present invention.

## Claims

1. A portable device with prolonged working hours, comprising:
a radio frequency process module for modulating a baseband signal and generating a radio frequency signal;
an antenna module for sending out the radio frequency signal;
a Power Amplifier (PA) process module connected to the radio frequency process module and the antenna module respectively, comprising a PA module for amplifying the power of the radio frequency signal, wherein,
the PA module works in an idle state when no radio frequency signal passes;
and, transmits the radio frequency signal directly to the antenna module when the output power of the antenna module is not larger than the maximum input power which the portable device can provide for the antenna module, amplifies the power of the radio frequency signal through the PA module and sends the radio frequency signal with an amplified power to the antenna module when the output power of the antenna module is larger than the maximum input power which the portable device can provide for the antenna module.

2. The portable device according to Claim 1, further comprising:
a baseband control module;
a switch module in the PA process module, wherein,
the baseband control module is used to send a control signal to the switch module for transmitting the radio frequency signal directly to the antenna module when the output power of the antenna module is not larger than the maximum input power which the portable device can provide for the antenna module; and to send a control signal to the switch module for transmitting the radio frequency signal to the antenna module through the PA module when the output power of the antenna module is larger than the maximum input power which the portable device can provide for the antenna module;
the switch module is used to transmit the received radio frequency signal directly to the antenna module, or to send the received radio frequency signal to the PA module for amplifying the power, and send the radio frequency signal with the amplified power to the antenna module according to the control signal sent by the baseband control module.

3. The portable device according to Claim 2, wherein, the switch module comprises two switches and a transmission line, one end of the first switch connects to the radio frequency process module, the other end connects to the PA module, one end of the second switch connects to the PA module, the other end connects to the antenna module, and the two switches are also connected with each other directly through the transmission line;
the switch module transmits the radio frequency signal received by the first switch directly to the antenna module through the transmission line and the second switch, or transmits the radio frequency signal received by the first switch to the PA module, and the second switch sends the radio frequency signal processed by the PA module to the antenna module according to the control signal sent by the baseband control module.

4. The portable device according to Claim 2, wherein, the radio frequency process module comprises:
a transmission modulation chip, which is used for implementing a modulation and gain amplification of the baseband signal, and the transmission of the processed radio frequency signal to a transmission filtering module;
the transmission filtering module, which is used for filtering the received radio frequency signal and transmitting the radio frequency signal to the PA process module after the filtering.

5. The portable device according to Claim 1, 2 or 4, wherein, the PA process module connects to the antenna module through the duplex module.

6. A method for prolonging working hours of a portable device, comprising:
acquiring a radio frequency signal, by the portable device, through a radio frequency modulation on a baseband signal;
configuring the work state of a Power Amplifier (PA) module in the portable device to be idle when no radio frequency signal passes;
determining, by the portable device, whether the transmission power of an antenna module in the portable device is larger than the maximum input power which the portable device can provide for the antenna module,
if the transmission power of the antenna module in the portable device is not larger than the maximum input power which the portable device can provide for the antenna module, the portable device sending out the modulated radio frequency signal directly through the antenna module, and ending the process;
otherwise the portable device amplifying the power of the modulated radio frequency signal through the PA module, and sending out the processed radio frequency signal through the antenna module.

7. The method according to Claim 6, wherein, the maximum input power which the portable device can provide for the antenna module is the maximum transmission frequency of the radio frequency signal acquired from the radio frequency modulation of the portable device.

8. The method according to Claim 6, where, the maximum input power which the portable device can provide for the antenna module is the difference of the maximum transmission frequency of the radio frequency signal acquired from the radio frequency modulation of the portable device and the transmission power loss of the portable device.

9. The method according to Claim 8, wherein, the portable device comprises a transmission filtering module which is used for filtering,
the transmission power loss comprises the power loss of the transmission filtering module;
the portable device comprises a duplex module which is used for duplex processing,
and the transmission power loss comprises the power loss of the duplex module.

10. The method according to Claim 8 or 9, wherein, the portable device controls the transmission of the radio frequency signal through a switch module, and the transmission power loss comprises the power loss of the switch module.
